Europäisches Patentamt

European Patent Office

Office européen des brevets

(11) Publication number: 0 395 886
A2

## EUROPEAN PATENT APPLICATION

(21) Application number: 90106056.6

(51) Int. Cl.5: **G11C 11/21**

(22) Date of filing: 29.03.90

(30) Priority: 03.04.89 JP 84446/89
03.04.89 JP 84448/89
25.05.89 JP 131862/89

(43) Date of publication of application:
**07.11.90 Bulletin 90/45**

(84) Designated Contracting States:
**CH DE GB LI NL**

(71) Applicant: **OLYMPUS OPTICAL CO., LTD.**
**43-2, 2-chome, Hatagaya Shibuya-ku**
**Tokyo 151(JP)**

(72) Inventor: **Oota, Yoshinori**
**Nishi-Hachioji-Corporus, 5-16-1,**
**Sanda-machi**
**Hachioji-shi, Tokyo(JP)**
Inventor: **Okada, Takao**
**432-6, Dairakuji-machi**
**Hachioji-shi, Tokyo(JP)**

Inventor: **Mimura, Yoshiyuki**
**686-28, Nishiterakata-machi**
**Hachioji-shi, Tokyo(JP)**
Inventor: **Yamada, Hidetoshi**
**2-37-5, Asahigaoka, Nerima-ku**
**Tokyo(JP)**
Inventor: **Mihara, Takashi**
**943-19, Araku**
**Iruma-shi, Saitama-ken(JP)**
Inventor: **Isono, Yasuo**
**B Green-Park, 1091-3, Kumagawamusashino**
**Fussa-shi, Tokyo(JP)**
Inventor: **Morimoto, Masamichi**
**3-6-2-B213, Oshitate-cho**
**Fuchu-shi, Tokyo(JP)**

(74) Representative: **Kuhnen, Wacker & Partner**
**Schneggstrasse 3-5 Postfach 1553**
**D-8050 Freising(DE)**

(54) Memory cell and multidimensinal memory device constituted by arranging the memory cells.

(57) A memory cell (10) includes a nonlinear conductivity element (12) constituted by an insulating layer (16; 56; 102) and conductor layers (18a, 18b; 86c, 100) opposite to each other to sandwich the insulating layer (16; 56; 102), and a charge holding element (Ca) which has charge holding characteristics, and is connected in series with the nonlinear conductivity element (12). When the plurality of memory cells (10) are arranged in a matrix form on an XY plane, a two-dimensional memory device (28) can be provided. In addition, when a plurality of layers including the plurality of memory cells (10) arranged in a matrix form are stacked, a three-dimensional memory device (38; 52) can be provided.

FIG. 1

## Memory cell and multi-dimensional memory device constituted by arranging the memory cells

The present invention relates to a memory element used in a technical field which deals with various types of information, images, and the like and, more particularly, to a memory cell using an MIM (metal-insulator-metal) junction element and a multi-dimensional memory device constituted by arranging the memory cells.

LSI techniques in an electronic field have been increasingly studied toward micropatterning. In particular, the research and development to achieve such micropatterning have been advanced in a field of a memory device in which a demand has strongly arisen for realizing a high density.

A conventional semiconductor memory device constituted by one- or two-dimensionally arranging a plurality of memory cells is known as the above memory device. As is generally known, a semiconductor memory cell is constituted by series-connecting a nonlinear conductivity element and a charge holding element. This memory cell has a memory function utilizing a hysteresis phenomenon which occurs when a voltage is applied to the nonlinear conductivity element. The nonlinear conductivity element using a semiconductor junction or a silicon thermal oxide film has been conventionally used.

When a semiconductor junction is used, the nonlinear conductivity element is two-dimensionally formed on a semiconductor single crystal. Since a micropatterning technique for a two-dimentional element substantially reaches a limit, it is difficult to expect that a memory capacity is remarkably increased by largely improving an integration degree of future elements.

In addition, when a silicon thermal oxide film is used, a precise and uniform ultrathin film having no defects such as a pin hole must be formed in order to provide a function as a tunnel barrier required to cause electrons to cause tunnel conduction in the silicon thermal oxide film. In order to form such a thin film, therefore, the thickness of the surface of a silicon single crystal is decreased by thermal oxidation. The characteristics of this thin film are often largely changed upon changes in various parameters. Therefore, high-precision process control must be performed, and it is difficult to form an element which can achieve a high production yield. In addition, since a silicon thermal oxide film is two-dimensionally formed on the surface of the silicon single crystal, it is difficult to expect a large increase in integration degree, as in the semiconductor junction.

Thus, since the development of techniques toward ultra-micropatterning almost reaches a limit, research has been progressively made to realize a three-dimensional integrated circuit in order to achieve a high-density and high-speed memory device having a multifunction. At present, however, in a memory device using a semiconductor such as silicon as a major material, a three-dimensional device cannot be realized unless most advanced, difficult techniques for realizing high-temperature emission, high-intensity light emission, or a high-intensity electron beam emission are utilized. In the semiconductor memory device manufactured by such techniques, a limit of the number of stacked layers is about three in practical use. An average density is also lower than that in a semiconductor memory device having a single-layer memory array by several orders. Even if a three-dimensional device can be realized, a density is not increased very much in practice.

The present inventors have developed a memory device which can be constituted without using a semiconductor such as a silicon as a major material. This device is disclosed in USP Application No. 07/398,271 (EPC Application No. 89115861.0). This application discloses a memory cell using a plurality of MIM junction elements, and a memory device in which these memory cells are two-dimensionally arranged.

Since the memory cell in this application is different from the above-mentioned memory cell using a semiconductor as a major material, the above problems can be solved, and a high-density device can be expected. However, a three-dimensional memory device is not developed, but only a two-dimensional memory device has been developed.

In the memory cell in the above application, a plurality of MIM junction elements are used. Therefore, this memory cell has a problem of a large number of manufacturing steps which require time-consuming manufacturing.

It is, therefore, an object of the present invention to provide a memory cell, using an MIM (metal-insulator-metal) junction element, which can be easily manufactured.

It is another object to provide a multi-dimensional memory device constituted by arranging such memory cells.

According to the first aspect of the present invention, there is provided a memory cell comprising: a nonlinear conductivity element including an insulating layer and conductor layers which sandwich the insulating layer, and are opposite to each other; and a charge holding element having charge holding characteristics and connected in series with said nonlinear conductivity element.

According to the second aspect of the present invention, there is provided a memory device comprising: a plurality of memory cells arranged in a matrix form on an XY plane, each of the memory cells including a nonlinear conductivity element having an insulating layer and conductor layers opposite to each other to sandwich the insulating layer, and a charge holding element having charge holding characteristics and connected in series with the nonlinear conductivity element; a plurality of X electrode lines, each of which commonly connects the memory cells arranged in a single X row; a plurality of Y electrode lines, each of which commonly connects the memory cells arranged in a single Y column; and a read capacitor arranged on one of the plurality of X and Y electrode lines.

This invention can be more fully understood from the following detailed description when taken in conjunction with the accompanying drawings, in which:

Fig. 1 is a view showing an arrangement of a memory cell according to an embodiment of the present invention;

Fig. 2 is a view showing a circuit arrangement to examine current-voltage characteristics of an MIM junction element shown in Fig. 1;

Fig. 3 is a graph showing current-voltage characteristics of the MIM junction element shown in Fig. 1;

Fig. 4 is a graph showing $\log(I/V^2)$-$(1/V)$ characteristics of the MIM junction element shown in Fig. 1;

Figs. 5A to 5D, and 6 are graphs showing a hysteresis phenomenon of the memory cell shown in Fig. 1;

Fig. 7 is a circuit diagram showing an arrangement of a two-dimensional memory device according to the second embodiment of the present invention;

Fig. 8 is a circuit diagram showing an arrangement to confirm write and read operations in the two-dimensional memory device shown in Fig. 7;

Fig. 9 is a graph showing waveforms of a write pulse, a read pulse, and a capacitor voltage;

Fig. 10 is a perspective view showing an arrangement of a three-dimensional memory device according to the third embodiment of the present invention;

Fig. 11 is a perspective view showing an arrangement of a three-dimensional memory device according to the fourth embodiment of the present invention;

Fig. 12 is a sectional view obtained by taking the three-dimensional memory device shown in Fig. 10 along the plane parallel to the YZ plane;

Fig. 13 is a plan view showing a wiring pattern of an electric-system wiring layer in the three-dimensional memory device shown in Fig. 10;

Fig. 14 is a perspective view of the electric-system wiring layer in the three-dimensional memory device shown in Fig. 10;

Figs. 15 and 16 are schematic views showing address selection and data input/output wiring patterns and switches;

Fig. 17 is a sectional view showing an arrangement of a three-dimensional memory device according to the fifth embodiment of the present invention;

Figs. 18A to 18F are sectional views sequentially showing the steps in manufacturing a charge holding element in the three-dimensional memory device shown in Fig. 17;

Fig. 19 is a sectional view showing an arrangement of the first modification of the charge holding element which can be applied to the three-dimensional memory device shown in Fig. 17;

Figs. 20A and 20B are sectional views sequentially showing the steps in manufacturing the charge holding element shown in Fig. 19;

Fig. 21 is a sectional view showing an arrangement of the second modification of the charge holding element which can be applied to the three-dimensional memory device shown in Fig. 17;

Figs. 22A to 22D are sectional views sequentially showing the steps in manufacturing the charge holding element shown in Fig. 21;

Fig. 23 is a sectional view showing an arrangement of the third modification of the charge holding element which can be applied to the three-dimensional memory device shown in Fig. 17;

Figs. 24A to 24E are sectional views sequentially showing the steps in manufacturing the charge holding element shown in Fig. 23;

Fig. 25 is a sectional view showing an arrangement of the fourth modification of the charge holding element which can be applied to the three-dimensional memory device shown in Fig. 17;

Figs. 26A to 26D are sectional views sequentially showing the steps in manufacturing the charge holding element shown in Fig. 25;

Fig. 27 is a sectional view showing an arrangement of the fifth modification of the charge holding element which can be applied to the three-dimensional memory device shown in Fig. 17;

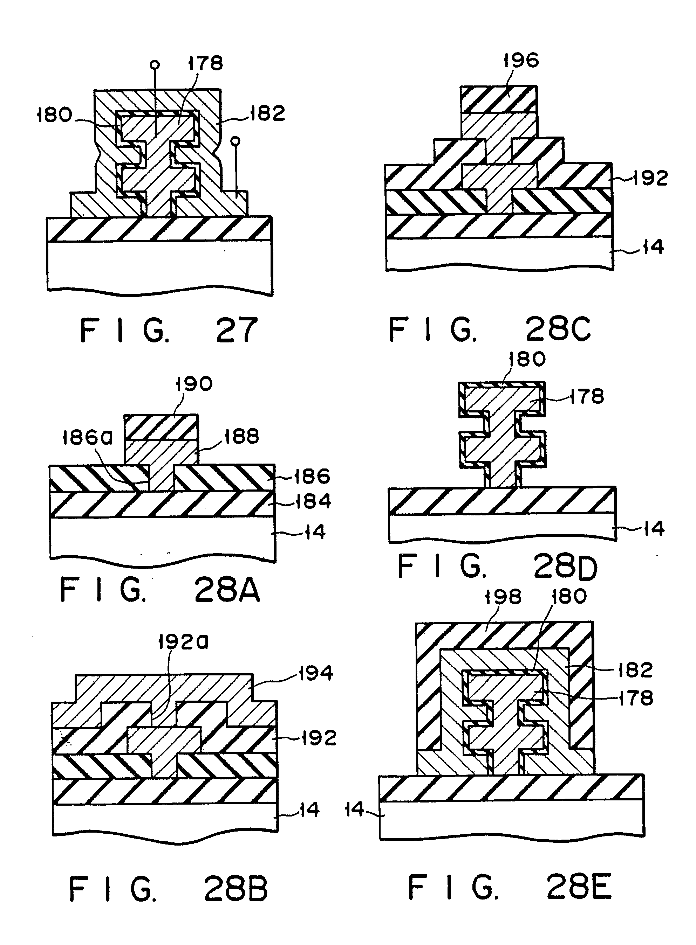

Figs. 28A to 28E are sectional views sequentially showing the steps in manufacturing the charge

3

holding element shown in Fig. 27;

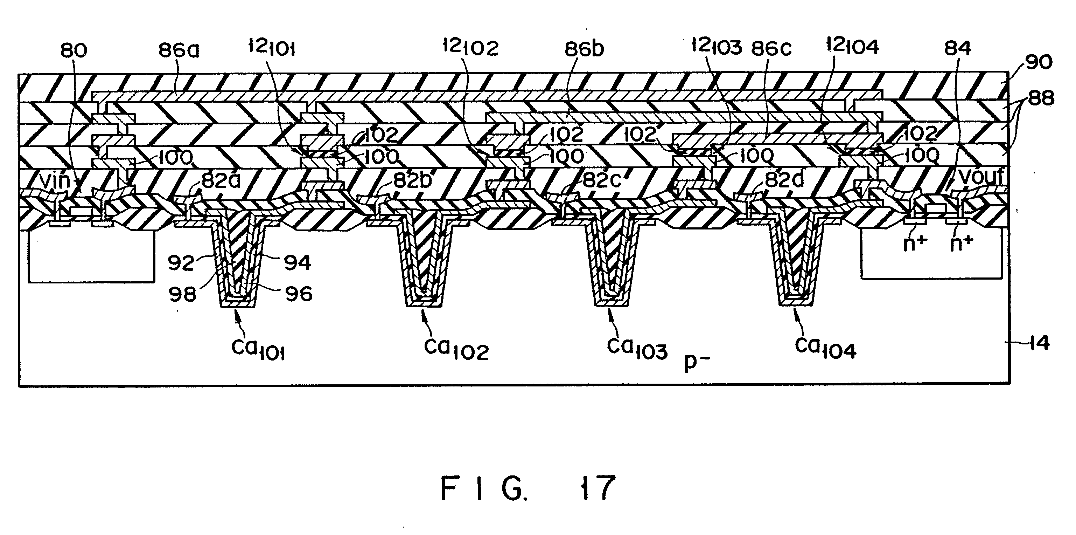

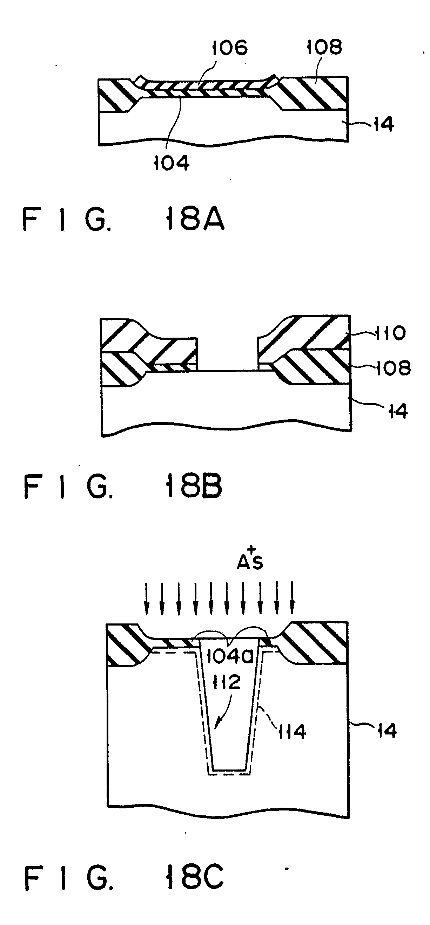

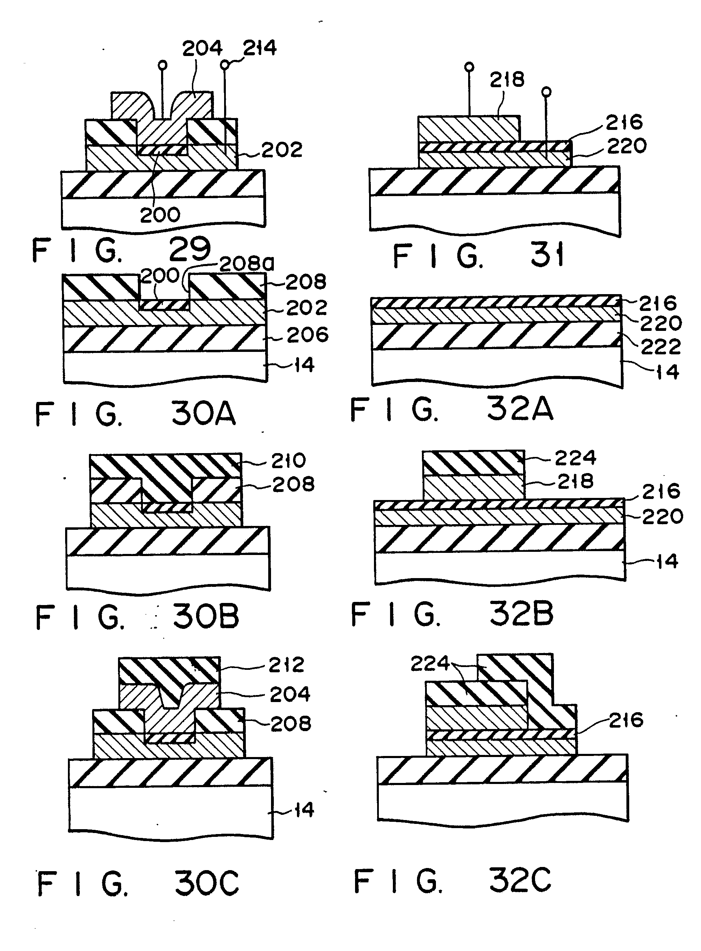

Fig. 29 is a sectional view showing an arrangement of the sixth modification of the charge holding element which can be applied to the three-dimensional memory device shown in Fig. 17;

Figs. 30A to 30C are sectional views sequentially showing the steps in manufacturing the charge holding element shown in Fig. 29;

Fig. 31 is a sectional view showing an arrangement of the seventh modification of the charge holding element which can be applied to the three-dimensional element shown in Fig. 17;

Figs. 32A to 32C are sectional views sequentially showing the steps in manufacturing the charge holding element shown in Fig. 31;

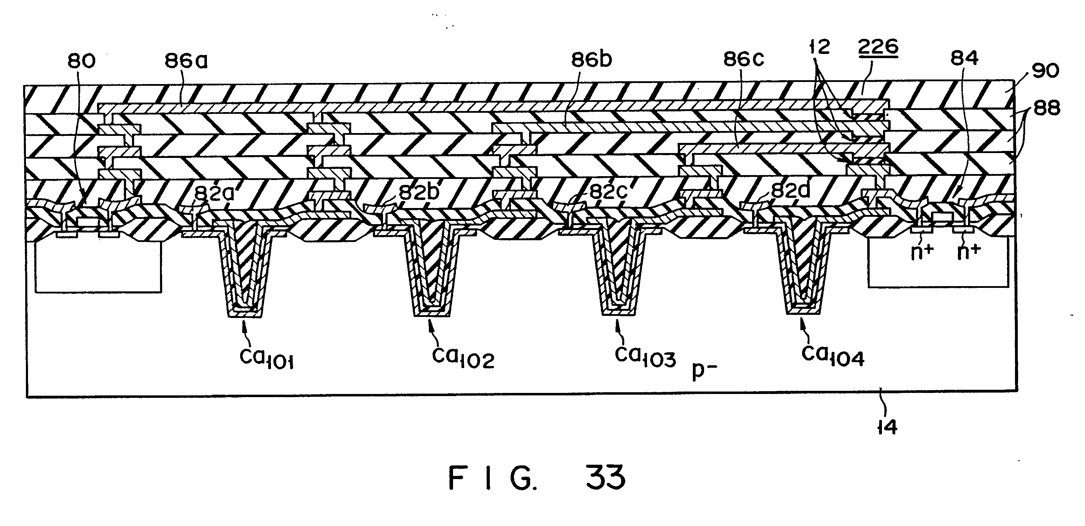

Fig. 33 is a sectional view showing an arrangement of a three-dimensional memory device according to the sixth embodiment of the present invention;

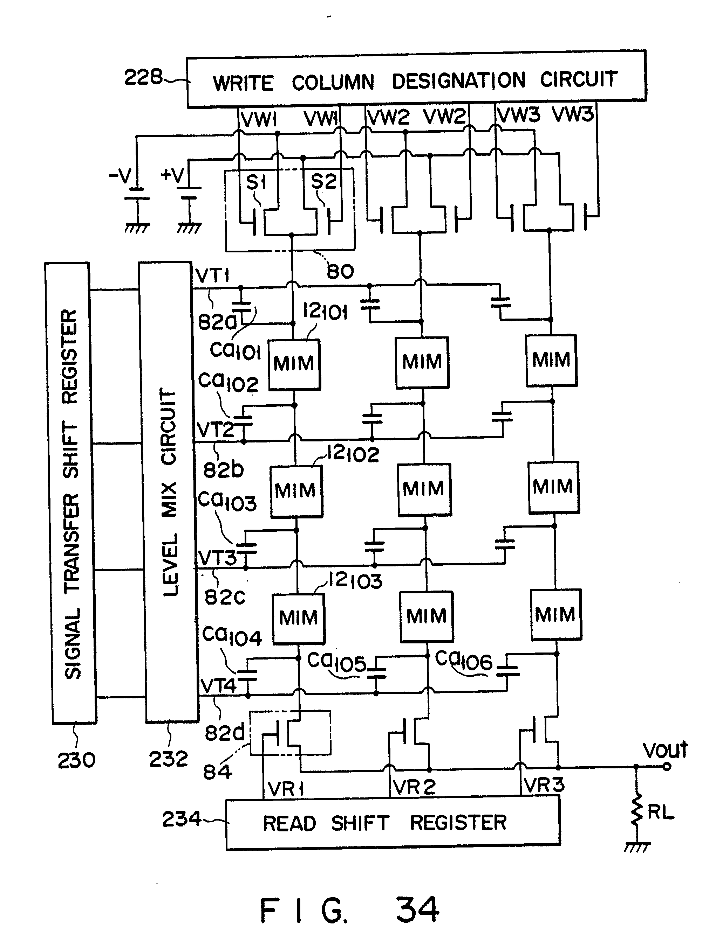

Fig. 34 is a circuit diagram showing an arrangement of the three-dimensional memory device shown in Fig. 33; and

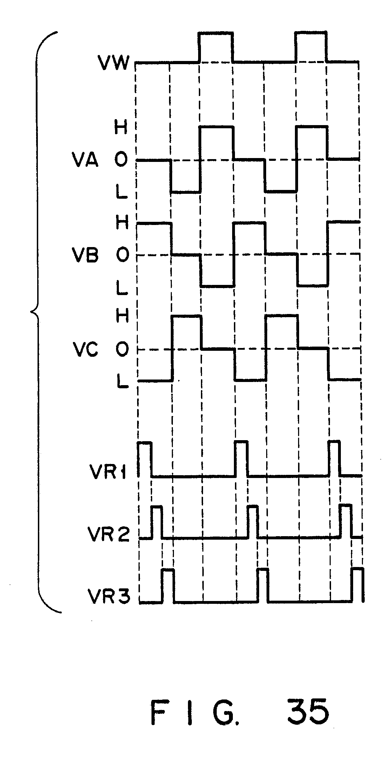

Fig. 35 is a timing chart of write, transfer, and read pulses.

Embodiments of the present invention will be described hereinafter with reference to the accompanying drawings.

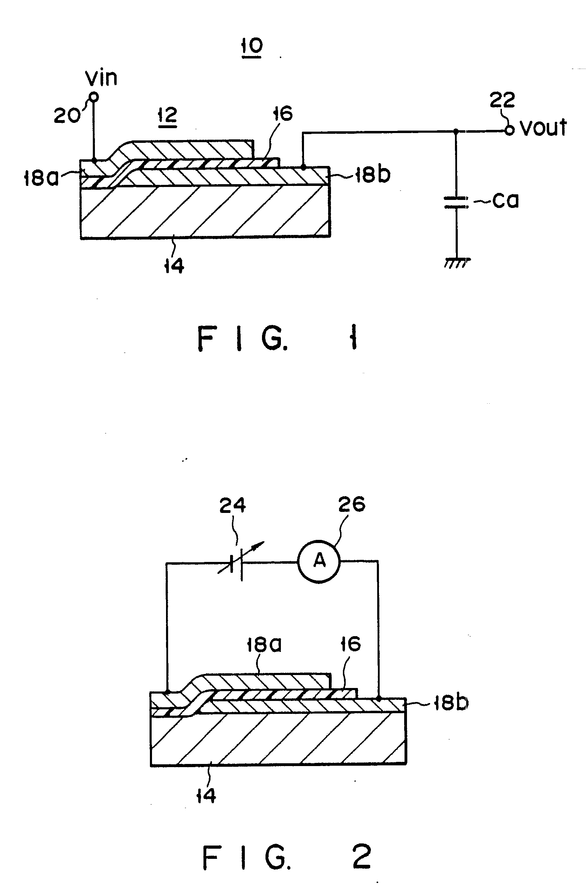

Fig. 1 is a view showing an arrangement of the first embodiment of the present invention. A memory cell 10 includes a nonlinear conductivity element 12 formed on a glass substrate 14. The nonlinear conductivity element 12 has an MIM (metal-insulator-metal) structure wherein a polyimide LB film (insulator) 16 is sandwiched between aluminum electrodes (metals) 18a and 18b. The nonlinear conductivity element 12 is referred to as an MIM element hereinafter. A terminal 20 is arranged at one electrode 18a, and a terminal 22 is arranged at the other electrode 18b. A capacitor Ca serving as a charge holding element having a grounded terminal is connected to the terminal 22. Note that a dielectric, ferroelectric, or charge trap material is preferably used for the capacitor Ca.

The memory cell 10 is formed by the following method. After an aluminum electrode 18b is formed on the glass substrate 14 by deposition, the polyimide LB film 16 formed by a method (to be described later) is stacked on the aluminum electrode 18b. The aluminum electrode 18a is formed on the polyimide LB film 16 by deposition.

The polyimide LB film 16 is formed as follows. First, a polyamide acid solution, prepared to have a concentration of 1 mmol/$\ell$ using a solution mixture of N,N-dimethylacetamide : benzene = 1 : 1 as a solvent, is mixed with an N,N-dimethyl-n-hexadecylamine solution dissolved in the same solvent as that of the polyamide acid solution, and prepared to have a concentration equal to that of the polyamide solution, at a molecular ratio of 1 : 2, thus obtaining a polyamide acid dielectric (polyamide acid and a salt of N,N-dimethyl-n-hexadecylamine) solution. This solution is used as an LB film developing solution. When this polyamide acid dielectric is developed on a water surface, the N,N-dimethyl-n-hexadecylamine component serves as a hydrophobic group, thus forming a monomolecular L film. The substrate is moved in and out along the vertical direction of the water surface with respect to the L film developed on the water surface to form a polyimide acid dielectric LB film on the substrate. The polyamide acid dielectric LB film thus formed is dipped into a solution mixture obtained by mixing acetic anhydride, pyridine, and benzene at a volume ratio of 1 : 1 : 3. Then, the added N,N-dimethyl-n-hexadecylamine is removed. In addition, the polyamide acid is changed into polyimide acid, and the polyamide LB film is changed into a polyimide LB film. In this embodiment, 30 LB films (thickness: 120 Å) are stacked. Note that the thickness of the polyimide LB film 16 preferably falls within the range of about 4 to 2,000 Å.

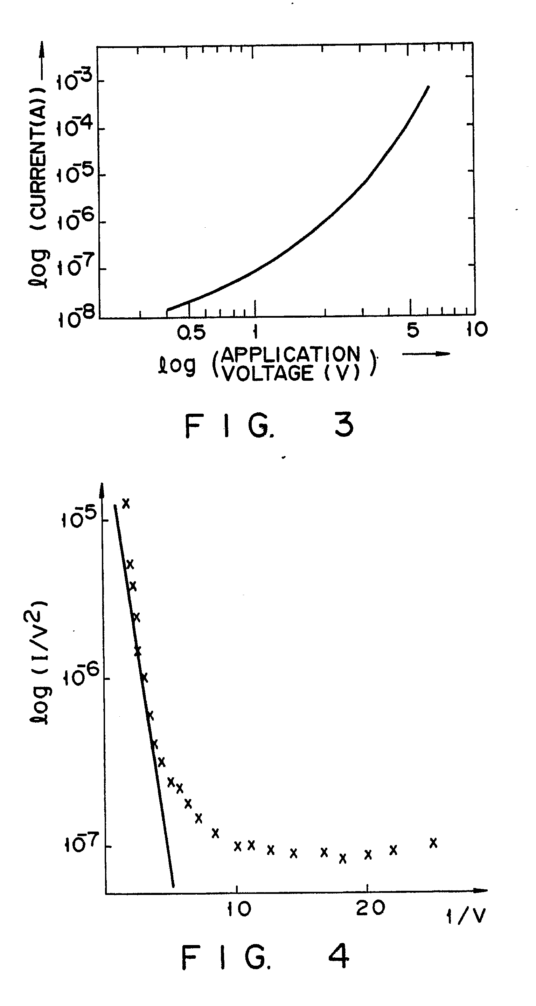

The present inventors measured application voltage dependency of the polyimide LB film thus formed. In this measurement, a circuit shown in Fig. 2 was arranged. Various voltages were applied from a variable power source 24 across the aluminum electrodes 18a and 18b, and currents supplied at that time were measured by a galvanometer 26.

Fig. 3 is a graph showing current-voltage characteristics of the polyimide LB film 16 thus measured. As shown in Fig. 3, in the polyimide LB film 16, when an application voltage is increased to ten times that an original voltage, a current supplied at this time is increased to about $10^5$ times that the original current. In Fig. 3, a current-voltage characteristic curve like an exponential function exhibits apparent nonlinear characteristics.

As is generally known, when a voltage is applied to an insulating thin film having a thickness of about several hundred of Å, a tunnel current flows. If a Fowler-Nordheim (R. H. Fowler and L. Nordheim, Proc. Roy. Soc. 119,173, 1928) tunnel current is supplied, the following relationship is present between an application voltage V and a current I:

$$I/V^2 = Bexp[-\{\frac{8\pi(2m)^{1/2}}{3he}d\psi_0^{3/2}\}\cdot(1/V)]$$

$$B = \frac{e^3}{4\pi n\psi_0 d^2}$$

where $m$ is a mass of an electron, $h$ is a Planck's constant, $e$ is a charge of the electron, $d$ is a thickness of the insulating film, and $\psi_0$ is a height of a potential barrier.

More specifically, a linear relationship is established between $\log(I/V^2)$ and $1/V$, and the gradient of the line is a function of the height $\psi_0$ of the potential barrier.

Fig. 4 shows a characteristic curve obtained by replotting the values on the basis of the data shown in Fig. 3. In Fig. 4, the axis of ordinate represents $\log(I/V^2)$, and the axis of abscissa represents $1/V$. Fig. 4 shows that $\log(I/V^2)$ and $1/V$ have a linear relationship within the range of $1/V = 0.2$ to $0.4$ $V^{-1}$. More specifically, it is known that a Fowler-Nordheim tunnel current is supplied to this voltage region. The height $\psi_0$ of the potential barrier of the polyimide LB film 16 was calculated to be $\psi_0 = 0.29$ eV on the basis of the gradient of this line.

A memory operation of the memory cell 10 shown in Fig. 1 with respect to an application voltage will be described hereinafter.

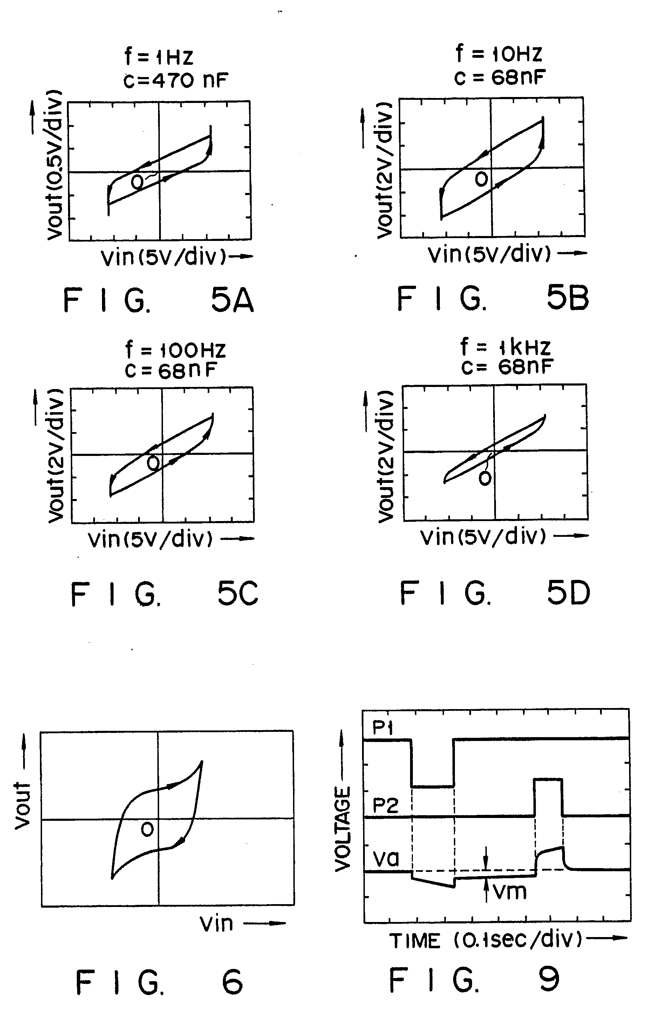

The present inventors set the area of each of the aluminum electrodes 18a and 18b to be 7 mm² using the polyimide LB film 16 obtained by stacking 40 layers (thickness: 160 Å). Conditions were changed such that rectangular-wave voltages $V_{in}$ having different frequencies were applied to the terminal 20 of the memory cell 10. A voltage $V_{out}$ output from the terminal 22 was measured. Figs. 5A to 5D show oscilloscopic waveforms obtained when measurement was performed in a voltage-voltage mode. In particular, Fig. 5A shows a case wherein a repeating frequency of a rectangular wave applied to the terminal 20 is set to satisfy $f = 1$ Hz, and a capacitance of the capacitor Ca is set to satisfy $C = 470$ nF; Fig. 5B shows a case wherein the repeating frequency is set to satisfy $f = 10$ Hz, and the capacitance is set to satisfy $C = 68$ nF; Fig. 5C shows a case wherein the repeating frequency is set to satisfy $f = 100$ Hz, and the capacitance is set to satisfy $C = 68$ nF; and Fig. 5D shows a case wherein the repeating frequency is set to satisfy $f = 1$ kHz, and the capacitance is set to satisfy $C = 68$ nF. Regardless of conditions, the voltage $V_{out}$ which appears at the terminal 22 exhibits a hysteresis phenomenon, and it was confirmed that this cell functioned as a memory cell. In this embodiment, a memory output voltage of about 0.5 V to 2.5 V was obtained.

Such a phenomenon shows that, since the MIM element 12 has large linear characteristics, charges accumulated in the capacitor Ca by a relatively high write voltage from the terminal 20 cannot flow out when a voltage is decreased below the write voltage, but they are kept stored in the capacitor Ca, and a voltage across the capacitor Ca generated by the charges is maintained as memory data.

Since such a memory cell 10 is formed using an LB film, the similar element can be easily formed on the aluminum electrode 18a through a proper insulating film, and a plurality of element layers can be stacked along the direction of thickness of the LB film. According to the memory cell 10 in this embodiment, therefore, the integration degree of the elements per substrate area can be remarkably increased. Upon the manufacture of the LB film, the semi-automatic process for parameter control has already been established. When such a technique is employed, therefore, a large number of LB films each having a large area can be manufactured in a high production yield, and hence a memory device having a large area can be easily manufactured.

The present inventors performed an experiment to input a triangular wave having a peak voltage of $Vp = \pm10$ V to the terminal 20 in the above-mentioned memory cell 10. Note that, in this case, a repeating cycle of the triangular wave was 1 Hz, and the capacitance of the capacitor Ca was 10 nF. When the voltage $V_{out}$ output from the terminal 22 was observed in a voltage-voltage mode of an oscilloscope, a clockwise hysteresis loop shown in Fig. 6 was observed.

The second embodiment of the present invention will be described below.

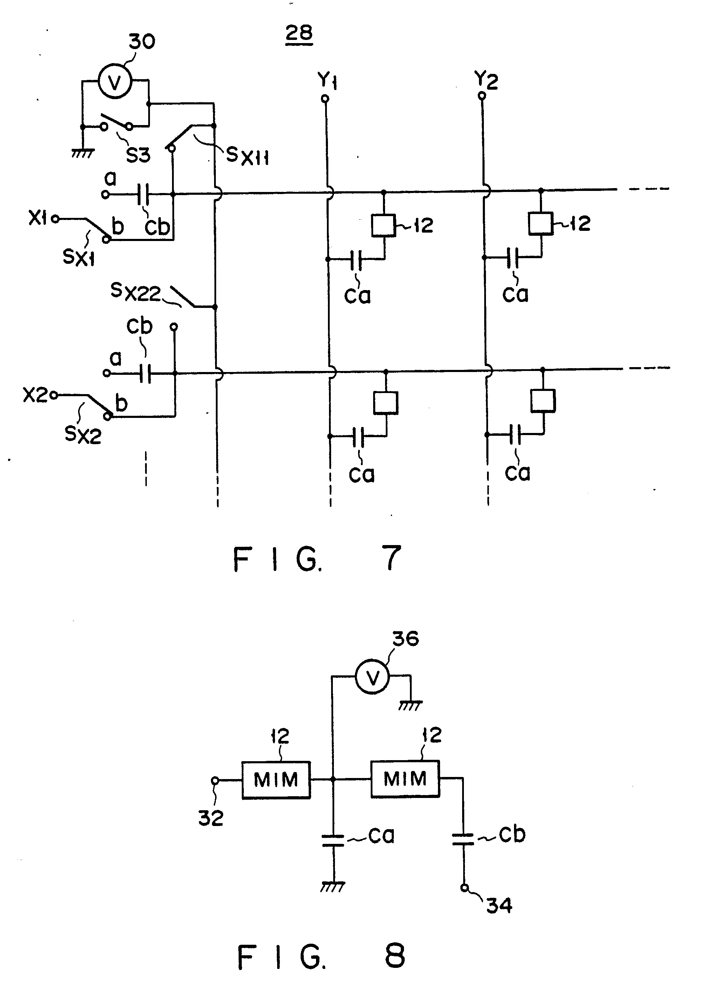

Fig. 7 is a circuit diagram showing an arrangement of a two-dimensional memory device 28 according to the second embodiment of the present invention. In the memory device 28, a large number of memory cells 10 described in the first embodiment are arranged on a substrate in a two-dimensional matrix form to constitute a memory array, and write and read operations are performed by X-Y addressing.

In the two-dimensional memory device 28, the terminal on an MIM element 12 side of each memory cell 10 arranged on each X row is commonly connected to the corresponding X electrode, and the terminal on a capacitor Ca side of each memory cell 10 arranged on a single Y column is commonly connected to the corresponding Y electrode. One terminal of each X electrode is connected to a voltage application terminal through a capacitor Cb or directly upon switching of a corresponding one of switches Sx1, Sx2, ... In addition, each X electrode can be grounded through the corresponding one of switches Sx11, Sx22, ..., and a common switch S3.

In the memory device 28 with the above arrangement, when a voltage pulse is applied between the X and Y electrodes, charges are held in capacitors Ca. Note that, in the memory device 28 in this embodiment, when voltages having different polarities are respectively applied to the X and Y electrodes, a charge is held in only the capacitor Ca positioned at specific (x, y) coordinates.

A case wherein charges are held in only the capacitor Ca at (x1, y1) coordinates will be exemplified and described hereinafter. If a write voltage for the memory cell 10 is Vp, a voltage of -Vp/2 is applied to the X1 electrode, and a voltage of Vp/2 is applied to the Y1 electrode while the switches Sx1, Sx2, ... are switched to the b sides. Other X and Y electrodes are grounded by the switches Sx22, ..., and S3. Then, a potential difference of Vp is generated in only the memory cell 10 at the coordinates (x1, y1), and a potential difference of only Vp/2 occurs in the memory cells at other coordinates. In this case, since the write voltage Vp is higher than a current enable voltage Vth of the MIM element 12 by about 30%, the potential difference of Vp/2 does not allow a write operation. Therefore, only the capacitor Ca at the coordinates (x1, y1) is addressed, and the charge is held therein. When such an operation is performed for other memory cells, charges can be independently held in the memory cells 10 at the respective coordinates.

A case wherein the charge held in the capacitor Ca of each memory cell 10 is independently read out will be described hereinafter, exemplifying the coordinates (x1, y1). First, a voltage of Vp/2 is applied to the X1 electrode, and a voltage of -Vp/2 is applied to the Y1 electrode while only the switch Sx1 of the X1 electrode is switched on the a side, and other X and Y electrodes are grounded. As a result, only the coordinates (x1, y1) are addressed, and the charge held in the capacitor Ca is read out. In this read operation, it is considered that the charge is stored from the memory cell 10 in the capacitor Cb arranged at the X1 electrode at the coordinates (x1, y1). More specifically, when the voltage Vp is applied to the memory cell 10 at the coordinates (x1, y1), a charge flows from the capacitor Ca which constitutes this memory cell 10, and the charge is supplied into the capacitor Cb of the X1 electrode and held. For this reason, if the switch Sx11 is turned on, and the switch S3 is turned off in a read mode, a voltage of the capacitor Cb can be observed. When a value on a galvanometer 30 is increased, a charge flows into the capacitor Cb, and it is confirmed that the charge is held in the capacitor Ca at the coordinates (x1, y1). If it is confirmed that the charge is held in the capacitor Ca, the switch S3 is turned on, and the capacitor Cb is discharged, thus completing one cycle of a read operation. Independent read operations can be performed in the memory cells 10 at other coordinates by the similar operations. Note that the capacitances of the capacitors Ca and Cb may not be equal to each other, and various combinations can be achieved.

In order to confirm write and read operations of the memory device 28 according to this embodiment, the present inventors manufactured a device having a circuit arrangement shown in Fig. 8, and an experiment was performed. The same reference numerals in Fig. 8 denote the parts having the same functions as in Fig. 7.

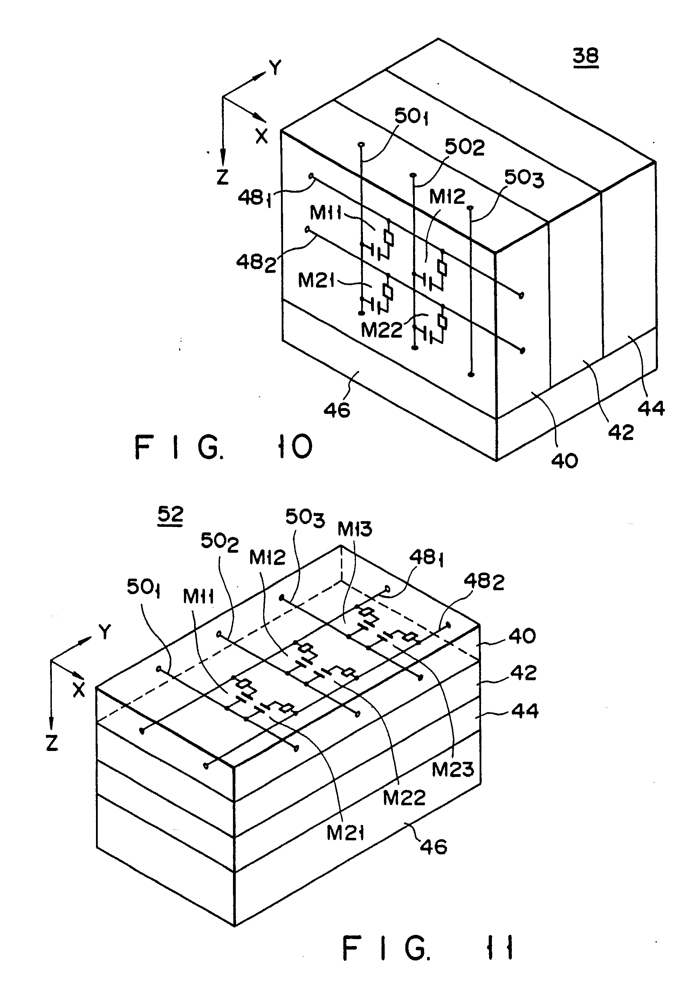

More specifically, in the circuit with the above arrangement, a voltage change of the capacitor Ca, obtained when a write pulse is applied to a terminal 32, and a read pulse is then applied to a terminal 34, was measured by an oscilloscope 36. This measurement result is shown in Fig. 9. In Fig. 9, P1 denotes a waveform (5 V/div) of a write pulse; P2, a waveform (10 V/div) of a read pulse; and Va, a voltage waveform (2 V/div) of the capacitor Ca. As shown in Fig. 9, when a negative write pulse is applied, a charge is held in the capacitor Ca. As a result, the voltage Va is kept at -Vm. This corresponds to an operation wherein a voltage is applied to the memory cell 10, and a charge is held in the capacitor Ca, in the memory device 28 shown in Fig. 7. When a read pulse having a polarity opposite to that of the write pulse is applied to the terminal 34, the charge held in the capacitor Ca flows out, and the voltage Va is set at 0. This corresponds to an operation wherein the charge held in the capacitor Ca in the memory device 28 shown in Fig. 7 flows out and is shifted to the capacitor Cb upon application of the voltage.

Thus, according to this embodiment, the same effect as in the first embodiment can be obtained. In addition, a large number of memory cells 10 shown in Fig. 1 are arranged on the two-dimensional plane, and data can be independently written in or read out from memory cells. Therefore, a memory area can be increased, and a memory capacity can also be increased. Furthermore, the operability of the two-dimensional memory device 28 obtained when the area is increased can be improved. Moreover, since the memory cell 10 can be easily formed, a large-capacity memory cell can be relatively easily formed.

Note that although the polyimide LB film is used as an insulating film for the MIM element 12 in the above embodiment, the present invention is not limited thereto, and other various organic and inorganic insulating films can be utilized.

The third embodiment of the present invention will be described below.

Fig. 10 shows an arrangement of a three-dimensional memory device 38 according to the third embodiment of the present invention. In the memory device 38, a plurality of (three in this embodiment) vertical two-dimensional memory arrays 40, 42, and 44 similar to the memory arrays in the two-dimensional memory device described in the second embodiment are sequentially arranged in the horizontal direction (Y direction). More specifically, in each of the two-dimensional memory arrays 40, 42, and 44, memory cells M11 to M22 serving as basic units are two-dimensionally arranged. Each of the memory cells M11 to M22 consists of an MIM element 12 having nonlinear current-voltage characteristics and a capacitor Ca serving as a charge holding element, as shown in Fig. 1. Therefore, when a predetermined wiring operation is performed for the above structure, a three-dimensional integrated memory device can be realized. In Fig. 10, reference numerals $48_1$, $48_2$, ... denote horizontal selection lines; and $50_1$, $50_2$, $50_3$, ..., vertical selection lines.

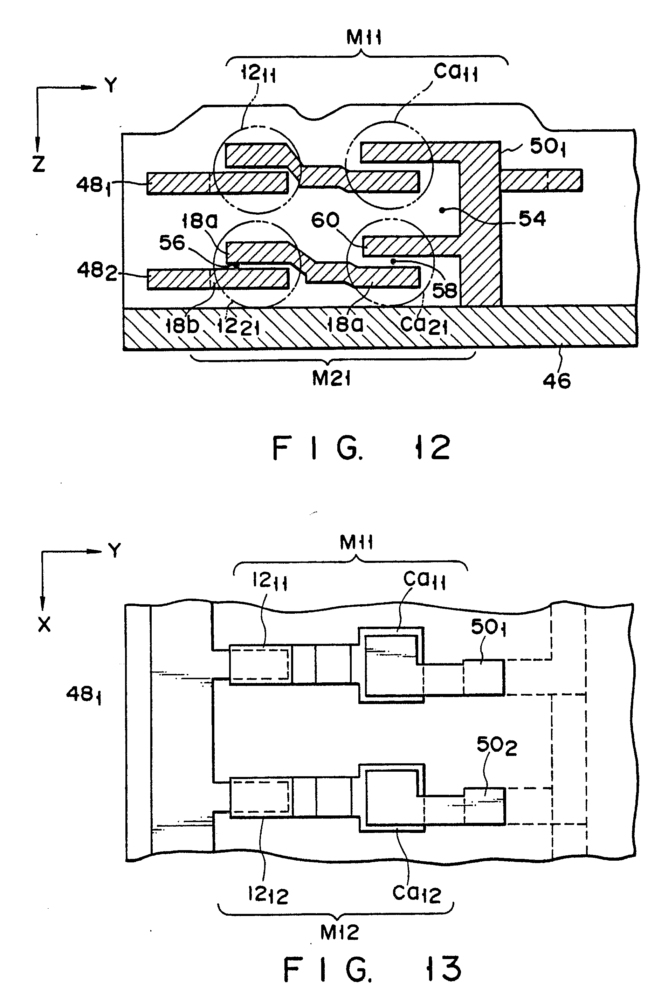

Fig. 11 shows an arrangement of the fourth embodiment of the present invention. In a three-dimensional memory device 52, two-dimensional memory arrays 40, 42, and 44 are stacked in a vertical direction. Basically, this structure is not different from that shown in Fig. 10 at all. Therefore, the device shown in Fig. 10 will be described hereinafter.

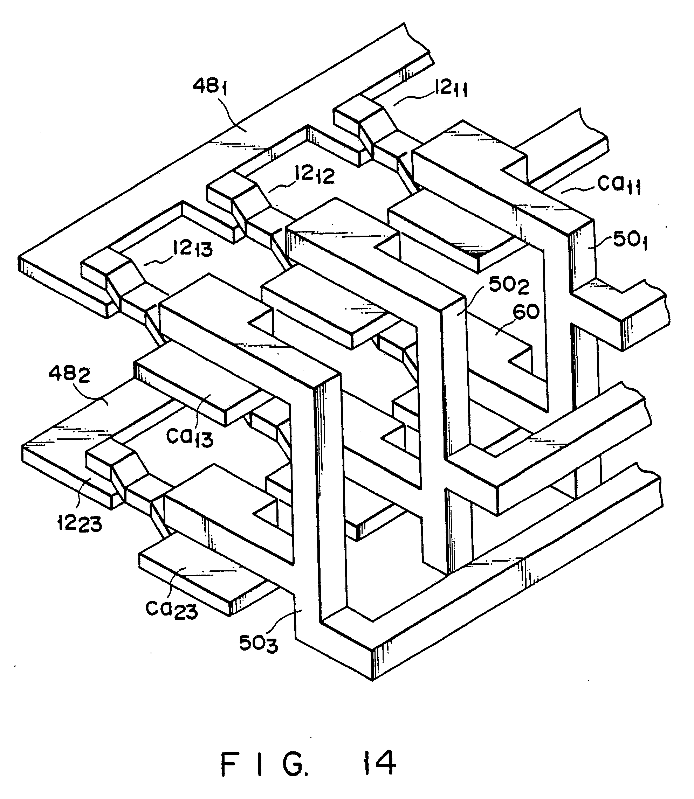

Fig. 12 is a sectional view obtained by taking the device shown in Fig. 10 along the plane parallel to the YZ plane. Fig. 13 is a plan view showing a wiring pattern of an electric-system wiring portion on the XY plane. Fig. 14 is a perspective view showing the electric-system wiring portion.

Referring to Figs. 12 to 14, the MIM elements 12 are shown on the left side with respect to the center, and the capacitors Ca serving as charge holding elements are shown slightly to the right of the MIM elements 12. The upper and lower cells (e.g., the memory cells M11 and M21) are separated by an insulating interlayer 54. Reference numerals $48_1$, $48_2$, ... denote wiring layers for designating a coordinate (Z-coordinate) in the direction of depth; and $50_1$, $50_2$, ..., wiring layers for designating the positions of the cells with respect to the direction (X-direction) which extends in parallel to the substrate 46 of the memory array.

A material and a method of manufacturing the above device will be described below. A sufficiently smooth insulating substrate may be selected as the substrate 46. A semiconductor substrate can be utilized as an insulating substrate. When a semiconductor substrate is used, however, insulation must be performed by an insulating film in a portion on which an electrode is formed. Wiring is performed by, e.g., deposition, or sputtering. First, etching and patterning using a metal mask are performed. An insulating film for, e.g., the MIM element $12_{21}$ if formed as follows. When an organic thin film is used, the insulating film is formed by a method which can form an ultraorganic film, such as an LB method, casting, or molecular beam epitaxy. By using these methods, an insulating film 56 is formed on a metal film (an aluminium electrode 18b and a wiring layer $48_2$). One end of an aluminium electrode 18a is arranged on a tunnel insulating film 56. An insulating film 58 such as the capacitor $Ca_{21}$ is formed on the other end of the electrode 18a by deposition, CVD, sputtering or the like, and a capacitor upper electrode 60 is formed on the insulating film 58. Thereafter, the insulating interlayer 54 is formed by deposition, CVD, sputtering, or spin coating, thus forming one-layer cell. When these steps are repeated to obtain a multi-layered memory cell structure.

In experiment conditions selected by the present inventors, 20 to 40 polyimide LB films (80 to 160 Å) were formed as the insulating film 56 of the MIM element 12. As the insulating film 58 and the interlayer insulating film 54 in the capacitor Ca, polyparaxylylene films (respectively having a thickness of 500 to 1,500 Å, and a thickness of 3,000 to 10,000 Å) can be properly used. As the metal wiring film, Aℓ, Cr, or the like is used to have a thickness of 500 to 2,000 Å.

When an inorganic insulating film is used as the insulating film 56 of the MIM element 12, sputtering, CVD, photo CVD, MOCVD, or MBE is employed. For example, $Si_3N_4$ or SiC may be preferably used for the insulating film 56.

In order to form the electrodes which extend in a direction of depth, i.e., the vertical selection lines $50_1$, $50_2$, $50_3$, ..., holes are formed by, e.g., dry etching after the film is formed. Thereafter, a metal is deposited.

When the charge holding characteristics of the capacitor Ca are to be reinforced, a ferroelectric (e.g., PLZT) insulating film or an insulating film (a film obtained by stacking $Si_3N_4$ and $SiO_2$ layers) including a trap is used.

The X-coordinate designating wiring layers, i.e., horizontal selection lines $48_1$, $48_2$, ... are stacked in a direction parallel to the X-axis and the substrate 46, and are connected to an external wiring layer.

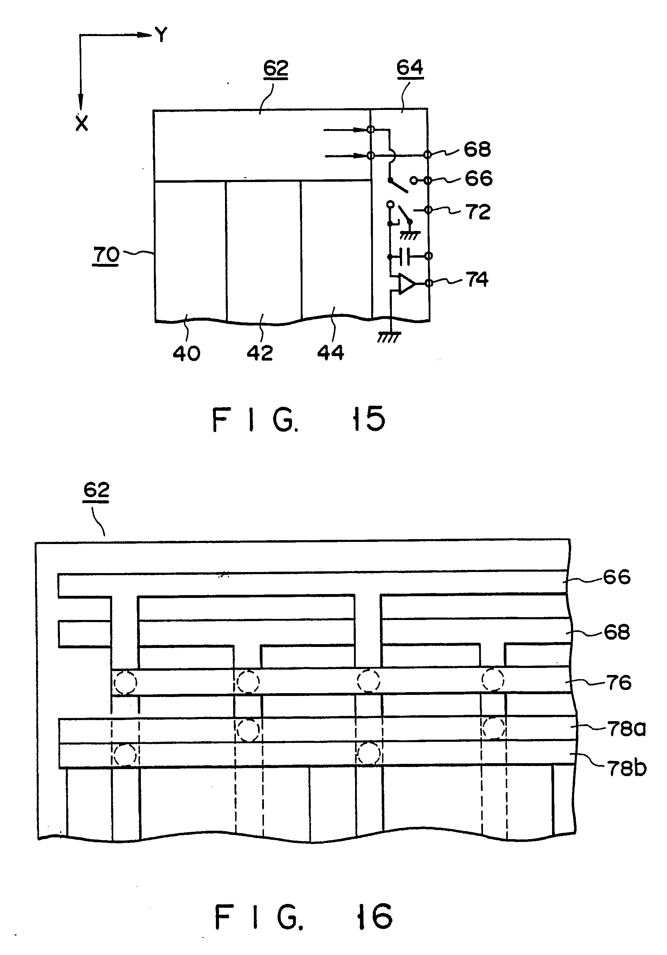

Figs. 15 and 16 are schematic views showing address selection and input/output wiring layers and switches.

Fig. 15 shows the entire memory. In Fig. 15, reference numeral 62 denotes an address switching section; 64, read and interface sections; 66, a Z pulse application line; 68, an X pulse application line; 70, a

7

memory array section; 72, a switching pulse terminal for a write/read operation; and 74, an output terminal.

Fig. 16 shows a detailed arrangement of the address switching section 62 shown in Fig. 15. In Fig. 16, reference numeral 76 denotes a Y selection line ($2l$ lines); and 78a and 78b, X selection lines ($2^m + 2^n$) lines . First, an address (Y) in the horizontal direction is designated by the Y selection line 76, and then, addresses in the vertical direction (X) and the direction of depth (Z) are designated by the X selection lines 78a and 78b. Address designation pulses in the X (vertical) and Z (depth) directions are applied through the pulse application lines 66 and 68, respectively. In Fig. 16, a dotted circle shows a line selection switch. The number of switches and an area of the switches (the area of the address switching section 62) are smaller than the area of the array section 70. If $2^m$, $2^l$, and $2^n$ memory cells 10 are respectively arranged in the X, Y, and Z directions, the number of the read switches is $(m + n + 1) \times 2^l$. If $m = n = l = 4$, the number of cells (the number of bits) is $16 \times 16 \times 16 \fallingdotseq 4k$ (bit), and the number of the read switches is $(4 + 4 + 1) \times 16$ $= 144$. If the area of the memory array section 70 in Fig. 15 when viewed from an upper portion corresponds to the area of $16 \times 16$ switches, the area of the address switching section 62 can be reduced to be substantially half the area of the memory array section 70.

According to this embodiment, the following function and effect can be achieved. Data can be easily output on the substrate 46 side. This effect is advantageous when, e.g., an arithmetic element is arranged on the substrate 46 side to perform an arithmetic operation. Note that, since an operation in each layer of the memory arrays 40, 42, and 44 is the same as in Fig. 7, and three-dimensional access in this embodiment is performed in substantially the same manner as in Fig. 1, a description thereof will be omitted.

The high-density property of this embodiment will be estimated hereinafter. It is proved by various scientific papers that a pattern having a thickness below 0.1 $\mu$m can be formed when an LB film is used as the insulating film 56 of the MIM element 12. Wiring of the interlayer insulating film can be performed with the same precision as that of a semiconductor LSI. Therefore, each cell area falls within the range of $2 \times 2$ $\mu$m$^2$ to $10 \times 10$ $\mu$m$^2$. A cell density in the planar direction is 1M to 16M bits/cm$^2$, and ten cells are formed in a direction of depth. A total cell density is 10M to 160M bits/cm$^2$ when cells are stacked in the direction of depth.

Three-dimensional and direct addressing has a great improved effect as compared with that of the conventional device because, in the conventional device disclosed in the above-mentioned application by the present inventors, a plurality of MIM elements are stacked, and direct addressing can be achieved for only uppermost and lowermost MIM elements in the direction of depth.

In such a three-dimensional memory device, the capacitance of the capacitor Ca serving as a charge holding element directly determines a memory capacity. Therefore, the capacitance of the charge holding element may be preferably as large as possible. In order to increase the capacitance of the charge holding element, the thickness of an insulator may be decreased, and the area of conductors which sandwich the insulator may be increased.

Since the area of the charge holding element is strictly limited because of a demand for high integration, however, it is difficult to obtain the area larger than the current area.

In order to increase a capacitance without increasing an area, the structure of the capacitor Ca is preferably arranged, as in the embodiment shown in Fig. 5.

Fig. 17 is a sectional view of one line of the three-dimensional memory device for the sake of description. More specifically, this three-dimensional device includes the following units as major elements. That is, a MOS write switch 80 operated by a write column designation circuit (not shown), trench capacitors $Ca_{101}$ to $Ca_{104}$ formed in a silicon substrate 14 in correspondence with MIM elements $12_{101}$ to $12_{104}$ for allowing tunnel-transmission of charges, charge transfer address lines 82a to 82d, one terminal of each of which is connected to the corresponding capacitor Ca, and the other terminal of each of which is connected to a level mix circuit (not shown), and a MOS read switch 84, connected to a read shift resistor (not shown), for reading out a charge from the capacitor $Ca_{104}$. Note that, in practice, a plurality of structures described above are arranged in the two-dimensional direction.

One electrode of the capacitor $Ca_{101}$ is connected to a conductive layer 86a through the MIM element $12_{101}$, and the other electrode thereof is connected to the charge transfer address line 82a. One electrode of the capacitor $Ca_{102}$ is connected to the charge transfer address line 82b, and the other electrode thereof is connected to a conductive layer 86b connected to the conductive layer 86a through the MIM element $12_{102}$. Similarly, one electrode of the capacitor $Ca_{103}$ is connected to the charge transfer address line 82c, and the other electrode thereof is connected to a conductive layer 86c through the MIM element $12_{103}$. One electrode of the capacitor $Ca_{104}$ is connected to the charge transfer address line 82d, and the other electrode thereof is connected to the conductive layer 86c through the MIM element $12_{104}$. The other electrode is also connected to the read switch 84. In addition, an insulating interlayer 88 is formed between

EP 0 395 886 A2

the adjacent conductive layers 86a to 86c, and a surface protective film 90 is formed on the conductive layer 86a serving as an uppermost layer.

In each capacitor Ca, an n-type diffusion layer 92 is formed in a surface layer region of a groove formed in the surface of the silicon substrate 14, and an oxide film 94 is formed on the surface of the n-type diffusion layer 92. In addition, a polysilicon layer 96 is formed on the oxide film 94 to have a uniform thickness, and a silicon oxide film ($SiO_2$) 98 is formed on the polysilicon layer 96 to fill the groove. An A$\ell$ electrode is formed on the n-type diffusion layer 92 and a part of the polysilicon layer 96 extracted outside the groove.

A method of manufacturing the three-dimensional memory element with the above arrangement will be described hereinafter.

First, the capacitor Ca is formed on the silicon substrate 14 by a method to be described later. In addition, peripheral circuits such as a write column designation circuit, a level mix circuit, a signal transfer shift register, and a read shift register are arranged.

Then, the surface of the silicon substrate 14 in which the capacitor Ca is formed is flattened. A through hole is formed at a position opposite to a portion on which the A$\ell$ electrode of each capacitor Ca and one electrode of the write switch 80 are formed, and a metal pad 100 electrically connected to the polysilicon layer 96 is formed. The insulating interlayer 88 is deposited by sputtering or an ECR plasma method which allows formation of a film at a low temperature in order to decrease a parasitic capacitance and to achieve interlayer insulation, and a through hole is formed in a prospective region of the MIM element 12. Then, an LB film is adhered to the entire surface of the substrate, and is selectively removed so that an LB film 102 is left in at least a prospective region of the MIM element 12. In addition, a metal film serving as the conductive layer 86c is deposited to form a pattern, thus forming the MIM element. The above steps are sequentially repeated to obtain a structure wherein each capacitor Ca is connected in parallel with the write switch 80 through the corresponding MIM element 12.

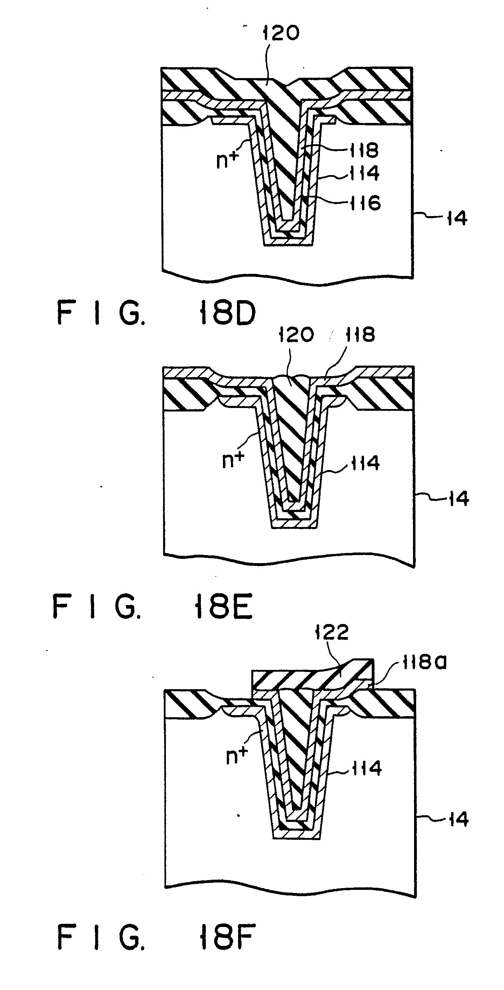

A method of manufacturing the capacitor Ca will be described below with reference to Figs. 18A to 18F. First, a silicon oxide film ($SiO_2$) 104 having a thickness of about 500 Å and a silicon nitride film ($Si_3N_4$) 106 having a thickness of 1,000 Å are formed on the p-type silicon substrate 14. When a pattern is formed by photolithography, and selective oxidation is performed to form a thick oxide film 108, as shown in Fig. 18A.

After the silicon nitride film 106 is removed, a PSG film 110 is deposited by CVD to have a thickness of about 1 $\mu$m. As shown in Fig. 18B, the PSG film 110 and the thin oxide film 106 in a prospective region of a groove to be formed in the silicon substrate 14 are removed.

Using the PSG film 110 as a mask, the silicon substrate 14 is subjected to reactive ion etching (RIE) to form a groove 112. Thereafter, the PSG film 110 is removed, and an n-type impurity such as As$^+$ or Sb$^+$ is ion-implanted using the thick oxide film 108 as a mask. As shown in Fig. 18C, an n-type diffusion layer 114 in which n-type impurity is doped is formed on the surface of the groove 112 and immediately under a thin oxide film 104a.

After the thin oxide film 104a formed on the surface of the silicon substrate 14 is removed, the surface of the diffusion layer 114 is oxidized again, thus forming a thin insulating film 116. A polysilicon layer 118 is deposited on the thin insulating film 116 to have a predetermined thickness, and a silicon oxide layer ($SiO_2$) 120 is formed on the polysilicon layer 118 by CVD to fill the groove, as shown in Fig. 18D.

The entire surface of the silicon oxide layer 120 is etched back to leave only the groove, as shown in Fig. 18E.

An opening region of the groove is masked by a photoresist 122 so that the polysilicon layer 118 is partially extracted from the groove, and the polysilicon layer 118 is subjected to reactive ion etching, thus forming a polycrystal electrode pattern 118a, as shown in Fig. 18F.

According to the three-dimensional memory device of the fifth embodiment, since a tunnel switching section is formed using the LB film 102, the memory cell can be easily formed in a three-dimensional direction, and an increase in memory capacity and density can be remarkably achieved. In addition, since the capacitor Ca is a trench capacitor, the surface area of the charge holding element can be increased although the area (a planar area on a chip) is small, and a memory capacity can be increased to about ten times the tunnel junction capacity shown in Fig. 12. Therefore, a chip area obtained when a high-density three-dimensional memory device is arranged can be decreased. In addition, since the capacitance of the capacitor Ca can be increased, held charges can be read out at a high S/N ratio.

Furthermore, since the capacitor Ca can be manufactured by the silicon process, the steps of forming the capacitor Ca can be included in the steps of forming the peripheral circuits such as the write and read switches 80 and 84, thus simplifying the steps in manufacturing the memory device. In addition, the capacitor Ca can be formed on the same chip on which the peripheral circuits such as the memory access, the write and read switches 80 and 84 are formed.

9

An improvement of the capacitor Ca shown in the fifth embodiment will be described hereinafter.

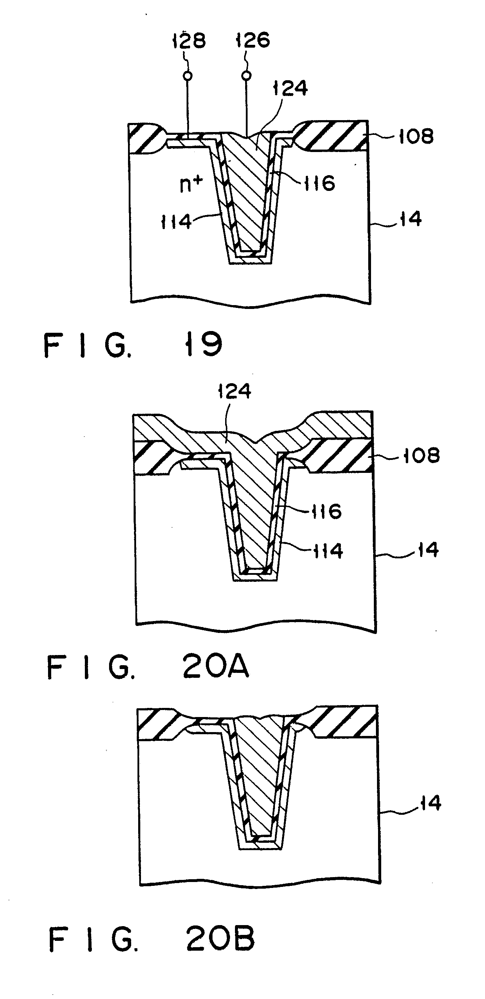

Fig. 19 shows an arrangement of the first modification of the capacitor Ca in the fifth embodiment. The capacitor Ca in this modification is a trench capacitor. The n-type diffusion layer 114 is formed on the surface of the groove formed in the surface of the p-type silicon substrate 14. The surface of the n-type diffusion layer 114 is coated with the insulating film 108, and an $n^+$-doped polysilicon layer 124 is deposited to fill the groove. Terminals 126 and 128 are connected to the n-type diffusion layer 114 and the polysilicon layer 124, respectively.

A method of manufacturing the capacitor Ca with the above arrangement will be described below.

The steps executed until the diffusion layer 114 is formed on the surface of the groove in the silicon substrate 14 are the same as those in Figs. 18A to 18C described in the fifth embodiment.

Then, the thin oxide film 104a is removed, and the n-type diffusion layer 114 is annealed and thermally oxidized to grow the thin oxide film 116 in order to form a capacitor. The $n^+$-doped polysilicon layer 124 is deposited by low pressure CVD, and the groove 112 is filled with the polysilicon layer 124, as shown in Fig. 20A.

The entire surface of the polysilicon layer 124 is etched back, and the polysilicon layer 124 is left in only the groove 112, as shown in Fig. 20B.

Finally, the terminals 126 and 128 are connected to the n-type diffusion layer 114 and the polysilicon layer 124, respectively, thus completing the steps of manufacturing the capacitor Ca.

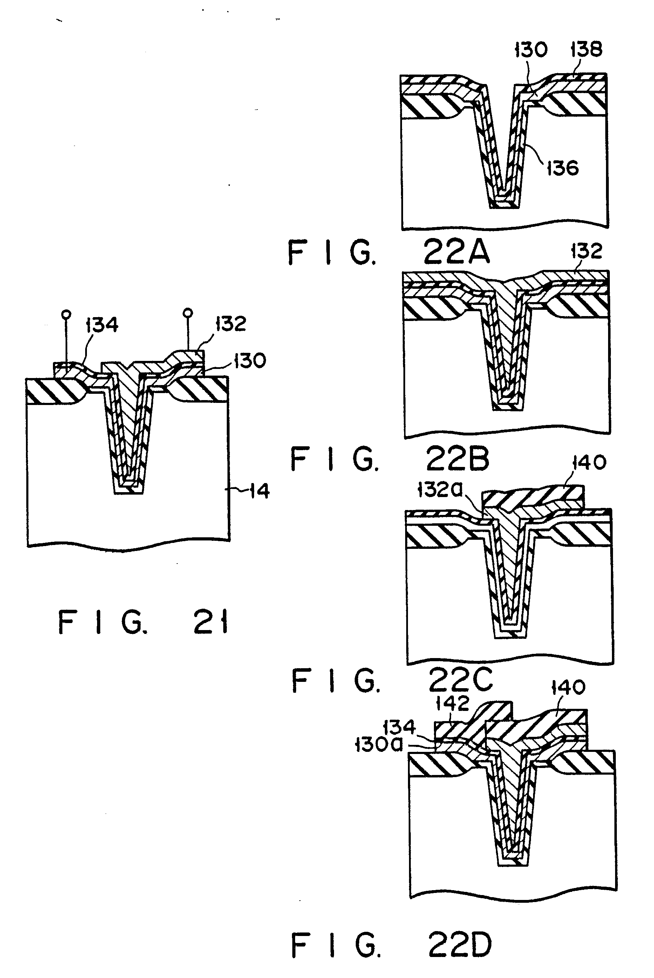

The second modification of the capacitor Ca in the fifth embodiment will be described hereinafter. As shown in Fig. 21, the capacitor Ca in this modification is constituted by conductive polysilicon layers 130 and 132 stacked and buried in the groove formed in the silicon substrate 14 and an insulating film 134 formed between the polysilicon layers 130 and 132.

When the capacitor Ca with the above arrangement is manufactured, a groove is formed in the surface of the silicon substrate 14. After an insulating film 136 is formed in the surface of the groove to achieve insulation, the first polysilicon layer 130 is deposited, and its surface is thermally oxidized to form a thin oxide film 138, as shown in Fig. 22A.

Then, the second polysilicon layer 132 is deposited on the oxide film 138 to fill the groove, as shown in Fig. 22B.

The second polysilicon layer 132 is etched using a photoresist 140 as a mask, and one electrode pattern 132a of the capacitor Ca is formed, as shown in Fig. 22C.

A photoresist 142 is additionally applied, and the oxide film 134 and the first polysilicon layer 130 are partially etched to form the other electrode pattern 130a, as shown in Fig. 22D.

Thus, the trench capacitor Ca shown in Fig. 21 can be manufactured.

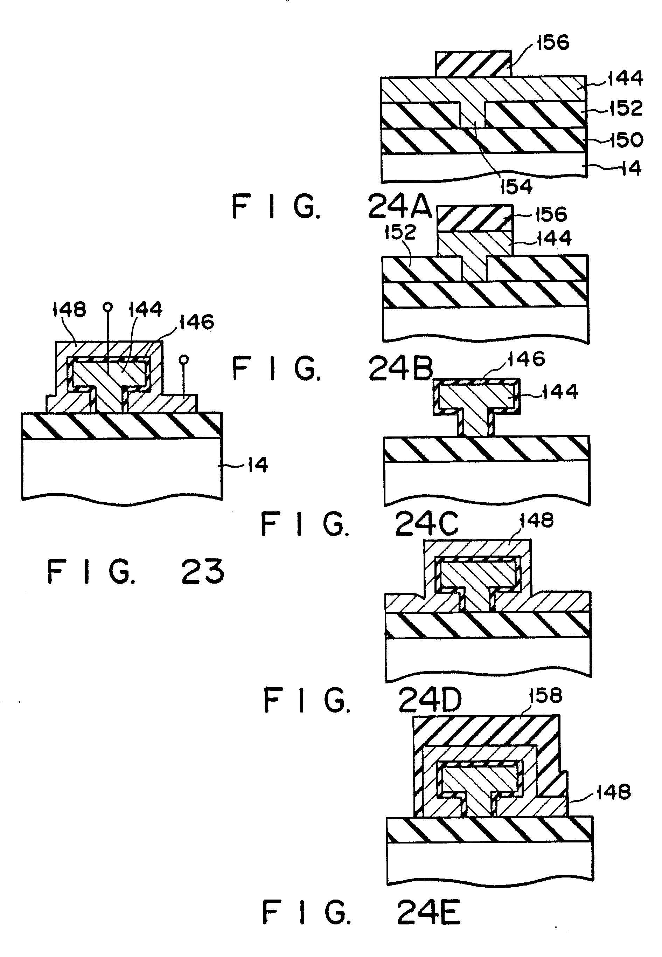

The third modification of the capacitor Ca will be described hereinafter. In this modification, the capacitor Ca is a multi-layered capacitor. As shown in Fig. 23, in the capacitor Ca in this modification, a first conductive polysilicon layer 144 having a T-shaped section is covered with an insulating film 146, and this insulating film 146 is coated with a second conductive polysilicon layer 148.

When the capacitor Ca with the above arrangement is manufactured, the silicon substrate 14 is thermally oxidized to form a silicon thermal oxide film ($SiO_2$) 150, and an insulating film, e.g., a PSG film 152, having an etching rate higher than that of the thermal oxide film 150 is deposited on the thermal oxide film 150. A hole 154 is formed in the PSG film 152 to reach the thermal oxide film 150, and the first polysilicon layer 144 is formed on the surface of the hole and the PSG layer 152. As shown in Fig. 24A, a resist pattern 156 having a width slightly larger than the diameter of the hole 154 is formed at a position opposite to the hole 154 on the polysilicon layer 144.

The polysilicon layer 144 is etched using the resist pattern 156 as a mask to form the first polysilicon layer 144 having a T-shaped section, as shown in Fig. 24B.

The resist 156 is removed, and the PSG layer 152 is selectively removed by an HF-based solution. Thereafter, the thin oxide film 146 is formed on the surface of the first polysilicon layer 144, as shown in Fig. 24C.

A polysilicon layer is deposited on the first polysilicon layer 144 on which the oxide film 146 is formed by low pressure CVD to form the second polysilicon layer 148 which covers the first polysilicon layer 144, as shown in Fig. 24D.

As shown in Fig. 24E, a resist 158 is formed, and the second polysilicon layer 148 is etched using the resist 158 as a mask, thus obtaining the capacitor Ca having the shape shown in Fig. 23.

According to the capacitor Ca thus manufactured, the charge holding region has a T-shaped section, and its surface area is increased. Therefore, a charge holding capacity can be increased, and hence an operation effect which is the same as that of the above-mentioned trench capacitor can be obtained.

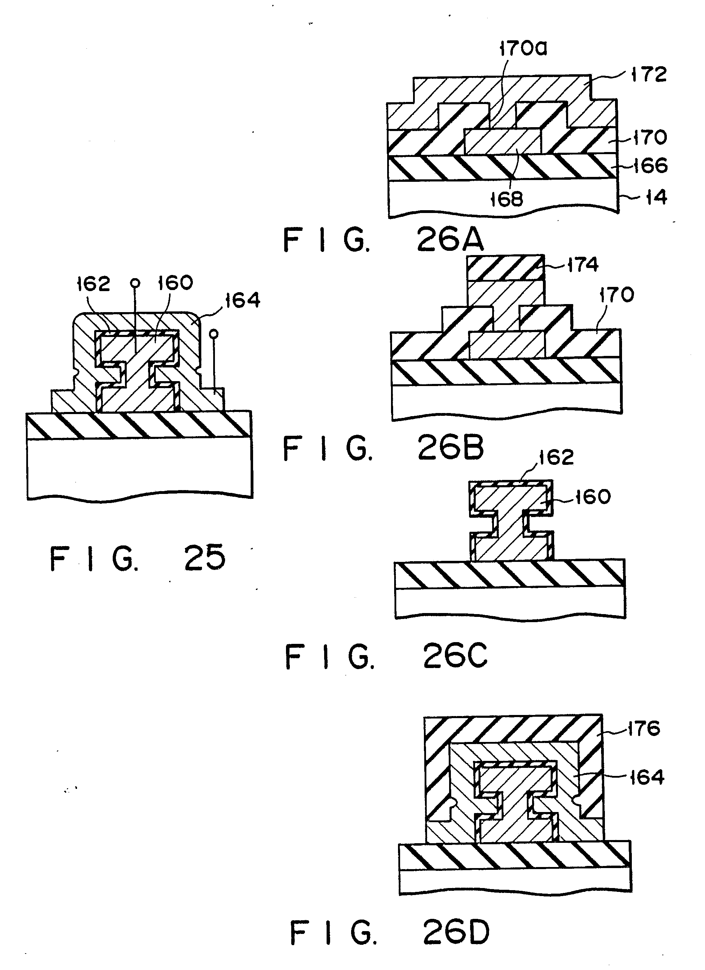

Fig. 25 shows the fourth modification of the capacitor Ca. In this modification, the charge holding region has an H-shaped section. The charge holding region includes a first polysilicon layer 160, an insulator 162, and a second polysilicon layer 164.

The steps in manufacturing the capacitor Ca will be described hereinafter.

First, the silicon substrate 14 is oxidized, and an oxide film 166 is formed on the surface of the substrate 14. After a first polysilicon layer is deposited on the oxide film 166, a pattern is formed by photolithography, thus forming a polysilicon layer 168 shown in Fig. 26A. A PSG film is deposited, and a hole 170a is formed from the PSG layer 170 to communicate with the polysilicon layer 168. A polysilicon layer 172 is deposited on the hole and the PSG layer 170.

As shown in Fig. 26B, using a resist mask 174, the polysilicon layer 172 having a width larger than the diameter of the hole 170a is patterned to be left.

The resist 174 and the PSG film 170 are selectively removed, and thermal oxidation is performed to form the thin oxide film 162 on the surface of the first polysilicon layer 160 having an H-shaped section, as shown in Fig. 26C.

The second polysilicon layer 164 is deposited on the entire surface of the insulating film 162 to form an electrode pattern which covers the first polysilicon layer 160 using a resist mask 176, as shown in Fig. 26D.

According to the capacitor Ca with the above arrangement, a larger amount of charge than that of the capacitor Ca shown in Fig. 23 can be accumulated.

Fig. 27 shows the fifth modification of the capacitor Ca. In this modification, the charge holding region has a section with a shape obtained by stacking two T-shaped layers. More specifically, the charge holding region includes a first polysilicon layer 178 having a section with a shape obtained by stacking two T-shaped layers, an insulating film 180 formed on the surface of the first polysilicon layer 178, and a second polysilicon layer 182 formed to coat the first polysilicon layer 178.

When the capacitor Ca with the above arrangement is manufactured, the silicon substrate 14 is oxidized to form an oxide film 184, and a first PSG film 186 is deposited on the oxide film 184. Then, a hole 186a which communicates with the oxide film 184 is formed in the PSG layer 186 by photolithography, and a polysilicon layer is deposited on the surface of the hole 186a and the PSG layer 186. Then, a resist mask 190 having a width larger than the diameter of the hole 186a is formed at a position opposite to the hole 186a formed in a polysilicon layer 188, and the polysilicon layer 186 is etched, as shown in Fig. 28A.

A second PSG film 192 is deposited, and a hole 192a having a diameter equal to that of the hole 186a is formed at a position opposite to the hole 186a formed in the PSG film 192. As shown in Fig. 28B, a polysilicon layer 194 is deposited on the surfaces of the hole 192a and the PSG layer 192.

A resist mask 196 having a width larger than the diameter of the hole 192a is formed in a predetermined region on the polysilicon layer 194 opposite to the hole 192a, and the polysilicon layer 194 is etched, as shown in Fig. 28C.

The resist 196 and the PSG layer 192 are removed to form the first polysilicon layer 178 having a section with a shape obtained by stacking two T-shaped layers. The surface of the first polysilicon layer 178 is oxidized, and the thin oxide film 180 serving as an insulating film is formed, as shown in Fig. 28D.

The second polysilicon layer 182 is deposited to coat the first polysilicon layer 178, and a resist 198 is formed, as shown in Fig. 28E. Using the resist 198 as a mask, the second polysilicon layer 182 is partially etched to form an electrode pattern.

According to such a capacitor Ca, a larger amount of charge than that of the capacitor Ca shown in Fig. 25 can be accumulated.

The sixth modification of the capacitor Ca will be described hereinafter. In this modification, as shown in Fig. 29, the capacitor Ca has a structure obtained by sandwiching an insulating film 200 constituted by $Ta_2O_5$ having a large permittivity (permittivity $\epsilon$ = 27) between conductive layers 202 and 204.

When the capacitor Ca with the above arrangement is manufactured, a thermal oxide film 206 is formed on the silicon substrate, and a tantalum (Ta) layer serving as the conductive layer 202 is deposited on the thermal oxide film 206 by electron beam deposition or sputtering. A silicon oxide layer 208 is deposited on the Ta layer 202 by CVD, and a hole 208a which communicates with the Ta layer 202 is formed in the silicon oxide layer 208. Then, Ta exposed on the surface of the hole 208a is changed into $Ta_2O_5$ by anodic oxidation to form the insulating film 200, as shown in Fig. 30A. Note that the thickness of the $Ta_2O_5$ layer 200 can be changed in accordance with an application voltage.

As shown in Fig. 30B, the silicon oxide layer 208 and the Ta layer 202 are etched using a resist 210 as a mask, thus forming a lower electrode pattern.

The resist 210 is removed, and the metal layer 204 serving as an upper electrode is deposited. Using a resist 210 as a mask, etching is performed to sandwich the $Ta_2O_5$ layer 200 between the Ta layer 202 and the metal layer 204, thus forming an upper electrode, as shown in Fig. 30C. A contact hole is formed in the silicon oxide layer 208 to extract a terminal 214 connected to the Ta layer 202 serving as a lower electrode.

Note that the contact hole may be formed using the resist mask prior to formation of the upper electrode, or after the metal layer 204 is deposited.

According to the capacitor Ca thus manufactured, the insulating film 200 constituted by $Ta_2O_5$ having a large permittivity is sandwiched between the conductive layers 202 and 204. Therefore, the amount of charge can be increased without increasing the area of the charge holding region.

The seventh modification of the capacitor Ca will be described hereinafter. As shown in Fig. 31, in this modification, a $Ta_2O_5$ layer 216 formed by sputtering or anodic oxidation is sandwiched between a metal layer 218 and a conductive layer 220 constituted by Ta or another metal.

When the capacitor Ca in this modification is manufactured, an oxide film 222 is formed on the silicon substrate 14. When a $Ta_2O_5$ layer is formed by sputtering, the conductive layer 220 constituted by Ta or another metal is deposited by deposition or sputtering, and the $Ta_2O_5$ layer 216 is formed on the conductive layer 220 by sputtering, as shown in Fig. 32A. When anodic oxidation is employed, the conductive layer 220 of Ta is deposited by deposition or sputtering, and the $Ta_2O_5$ layer 216 is formed on the conductive layer 220 by anodic oxidation.

The metal layer 218 serving as an upper electrode is deposited, and the metal layer 218 is etched using a resist 224 as a mask, thus forming an upper electrode. Thereafter, a resist is additionally applied, and the $Ta_2O_5$ layer 216 and the conductive layer 220 are partially etched to form a lower electrode, as shown in Fig. 32B.

Terminals are respectively arranged on the metal layer 218 and the conductive layer 220 constituted by Ta or another metal, thus manufacturing the capacitor Ca shown in Fig. 31.

Fig. 33 is a sectional view of the sixth embodiment of the present invention corresponding to Fig. 17. In a three-dimensional memory device of this embodiment, a plurality of MIM elements are stacked in place of an arrangement obtained by locating an MIM element near a capacitor Ca. More specifically, the three-dimensional memory device of this embodiment includes the following units as major elements, that is, a MOS write switch 80 operated by a write column designation circuit (not shown), a charge transfer path in which a plurality of MIM elements 12 are stacked to tunnel-transmit charges, trench capacitors $Ca_{101}$ to $Ca_{104}$ formed in a silicon substrate 14 in correspondence with MIM elements 12, charge transfer address lines 82a to 82d, one end of each of which is connected to the corresponding capacitor Ca, and the other end of each of which is connected to a level mix circuit (not shown), and a MOS read switch 84, connected to a read shift register (not shown), for reading out charges from the capacitor $Ca_{104}$. Note that, in practice, a plurality of above structures are arranged in a two-dimensional direction. Although three MIM element layers 12 are stacked in this embodiment for the sake of convenience, three or more layers can easily be stacked using an LB film.

A conductive layer 86a serving as an uppermost layer of a charge transfer path 226 is connected to the write switch 80, and the capacitor $Ca_{101}$. One electrode of the capacitor $Ca_{101}$ is connected to the conductive layer 86a, and the other electrode thereof is connected to the charge transfer address line 82a. One electrode of the capacitor $Ca_{102}$ is connected to the charge transfer address line 82b, and the other electrode thereof is connected to the other conductive layer 86b which constitutes an MIM structure together with the conductive layer 86a. Similarly, one electrode of the capacitor $Ca_{103}$ is connected to the charge transfer address line 82c, and the other electrode thereof is connected to the conductive layer 86c. One electrode of the capacitor $Ca_{104}$ is connected to the charge transfer address line 82d, and the other electrode thereof is connected to one conductive layer of the MIM element 12 serving as a lowermost layer, and the read switch 84. In addition, an insulating interlayer 88 is formed between the adjacent layers of the conductive layers 86a to 86c, and a surface protective film 90 is formed on the conductive layer 86a serving as an uppermost layer.

An operation of the three-dimensional memory device with the above arrangement will be described below with reference to Fig. 34. Fig. 34 is a circuit diagram showing an arrangement of an equivalent circuit of the three-dimensional memory device shown in Fig. 33. Fig. 34 shows a case wherein a charge transfer path 226 is formed to have three columns in the two-dimensional direction. In Fig. 34, reference symbol MIM denotes the MIM element 12, and one MIM element 12 and a capacitor Ca connected to the corresponding MIM element 12 constitute a memory cell. The MIM element 12 has a tunnel transmission mechanism which is variable at a conductance $GT \propto \exp(-t/V)$ (where t is the thickness of the insulating film of the MIM element 12, and V is a voltage applied to the MIM element 12) with respect to an application voltage.

In this three-dimensional memory device, a write pulse VW is applied from a write column designation circuit 228 at a timing shown in Fig. 35, and predetermined data are sequentially written in the capacitor calol. A transfer pulse VT is applied from a signal transfer shift register 230 or the level mix circuit 232 at a timing shown in Fig. 35 to transfer the charge accumulated in the capacitor $Ca_{101}$ to the capacitor $Ca_{102}$.

Read pulses VR are applied from a read shift register 234 to the capacitors $Ca_{104}$, $Ca_{105}$, and $Ca_{106}$ at a timing shown in Fig. 35 to read out the stored data therefrom.

For example, when data "1" is written in a memory cell designated by the first row and the first column, a switch S1 of the write switch 80 is turned on, a negative voltage V is applied to one electrode of the capacitor $Ca_{101}$, and a voltage VT1 (high level) is applied to the other electrode. More specifically, a voltage of VT1 - V is applied to the capacitor $Ca_{101}$. As a result, a charge of $(VT1-V)/C_0$ is held in the capacitor $Ca_{101}$, and data "1" is written. Note that reference symbol $C_0$ denotes a capacitance of the capacitor $Ca_{101}$. When data "0" is written, the write switch S2 is turned on, and a positive voltage V is applied, and the voltage Vt1 is set at high level. A voltage of (VT1-V) to 0 is applied across the capacitor $Ca_{101}$ to cancel the charge held in the capacitor $Ca_{101}$, thus writing data "0".

When a charge held in a memory cell designated by the first row and the first column is transferred to a memory cell designated by the first row and the second column, the transfer pulse VT1 is set at low level, and the transfer pulse VT2 is set at high level. Then, an (H + L) level voltage is applied to the MIM element $12_{101}$ designated by the first row and first column, thus setting the MIM element $12_{101}$ in an ON state (enable state). Therefore, the charge held in the capacitor $Ca_{101}$ is transferred to the capacitor $Ca_{102}$. When the charge accumulated in the capacitor $Ca_{102}$ is transferred to the capacitor $Ca_{103}$ in the next stage, the voltage VT2 is set at low level, and the voltage VT3 is set at high level. Note that VA, VB, and VC in Fig. 35 correspond to the voltages VT1 and VT4, VT2, and VT3 in Fig. 4, respectively.

A read operation is performed as follows. The transfer pulse VT4 set at low level is applied to the memory cells arranged in the last column, and a current supplied from the read shift register 234 to a load resistor RL by turning on the read switch 84 is measured. Since a current supplied to the load resistor RL is changed depending on an amount of charge held in the capacitor $Ca_{104}$, "1" or "0" is determined in accordance with an amount of supplied current.

As has been described above in detail, according to the present invention, since one nonlinear conductivity element having an MIM structure and a charge holding element constitute a memory cell, there is provided a memory cell which can be easily manufactured. In addition, since a two- or three-dimensional memory device can be easily realized using such a memory cell, a high-density memory device can be provided. Furthermore, since the area of a capacitor serving as the charge holding element is decreased, and the surface area of the charge holding region is increased, a sufficiently large amount of charge can be held although the area is small. A high integration degree and an increase in memory capacity can be achieved, and stored data can be read out in a state wherein an S/N ratio is excellent. In particular, when a structure wherein an insulating film constituted by $Ta_2O_5$ having a high permittivity is sandwiched between conductor layers is employed as a charge holding element, a memory capacity can be further increased.

## Claims

1. A memory cell characterized by comprising:
a nonlinear conductivity element (12) including an insulating layer (16; 56; 102) and conductor layers (18a, 18b; 86c, 100) which sandwich said insulating layer (16, 56, 102), and are opposite to each other; and
a charge holding element (Ca) having charge holding characteristics and connected in series with said nonlinear conductivity element (12).

2. The memory cell according to claim 1, characterized in that said insulating layer (16; 56; 102) includes a Langmuir-Blodgett film.

3. The memory cell according to claim 1, characterized in that said charge holding element (Ca) includes:
a diffusion layer (92; 114) formed along a surface of a groove (112) formed in a surface of a semiconductor substrate (14);
an insulating film (94; 116) formed to cover the surface of the groove (112) on which said diffusion layer (92; 114) is formed; and
a conductive polycrystal member (96; 118; 124) deposited on said insulating film (94; 116) to fill the groove (112).

4. The memory cell according to claim 1, characterized in that said charge holding element (Ca) includes:
a first insulating film (136) formed to cover the surface of the groove (112) formed in the surface of said semiconductor substrate (14);
a first conductive polycrystal member (130) deposited on said first insulating film (136) to have a predetermined thickness;

a second insulating film (134) formed to cover a surface of said first conductive polycrystal member (130); and

a second conductive polycrystal member (132) deposited on said second insulating film (134) to fill the groove (112).

5. The memory cell according to claim 1, characterized in that said charge holding element (Ca) includes:

a first insulating film (150; 166; 184) formed on a semiconductor substrate (14);

a first conductive polycrystal member (144; 160; 178) formed on said first insulating film (150; 166; 184), said first conductive polycrystal member having a large surface area;

a second insulating film (146; 162; 180) formed to cover a surface of said conductive polycrystal member (144; 160; 178); and

a second conductive polycrystal member (148; 164; 182) deposited to cover said second insulating film (146; 162; 180).

6. The memory cell according to claim 1, characterized in that said charge holding element (Ca) includes:

an insulating film (200) essentially consisting of $Ta_2O_5$; and

conductive layers (202, 204) opposite to each other to sandwich said insulating film (200).

7. A memory device characterized by comprising:

a plurality of memory cells arranged in a matrix form on an XY plane, each of said memory cells including a nonlinear conductivity element (12) having an insulating layer (16; 56; 102) and conductor layers (18a, 18b; 86c, 100) opposite to each other to sandwich said insulating layer (16; 56; 102), and a charge holding element (Ca) having charge holding characteristics and connected in series with said nonlinear conductivity element (12);

a plurality of X electrode lines, each of which commonly connects said memory cells arranged in a single X row;

a plurality of Y electrode lines, each of which commonly connects said memory cells arranged in a single Y column; and

a read capacitor (Cb; $Ca_{104}$, $Ca_{105}$, $Ca_{106}$) arranged on one of said plurality of X and Y electrode lines.

8. The memory device according to claim 7, characterized in that a plurality of layers including said plurality of memory cells arranged in a matrix form on the XY plane are stacked in a Z direction to constitute a three-dimensional memory device (38; 52).

9. The memory device according to claim 7 or 8, characterized in that said insulating layer (16; 56; 102) includes a Langmuir-Blodgett film.

10. The memory device according to claim 7 or 8, characterized in that said charge holding element (Ca) includes:

a diffusion layer (92; 114) formed along a surface of a groove (112) formed in a surface of a semiconductor substrate (14);

an insulating film (94; 116) formed to cover the surface of the groove (112) on which said diffusion layer (92; 114) is formed; and

a conductive polycrystal member (96; 118; 124) deposited on said insulating film (94; 116) to fill the groove (112).

11. The memory device according to claim 7 or 8, characterized in that said charge holding element (Ca) includes:

a first insulating film (136) formed to cover the surface of the groove (112) formed in the surface of said semiconductor substrate (14);

a first conductive polycrystal member (130) deposited on said first insulating film (136) to have a predetermined thickness;

a second insulating film (134) formed to cover a surface of said first conductive polycrystal member (130); and

a second conductive polycrystal member (132) deposited on said second insulating film (134) to fill the groove (112).

12. The memory device according to claim 7 or 8, characterized in that said charge holding element (Ca) includes:

a first insulating film (150; 166; 184) formed on a semiconductor substrate (14);

a first conductive polycrystal member (144; 160; 178) formed on said first insulating film (150; 166; 184), said first conductive polycrystal member having a large surface area;

a second insulating film (146; 162; 180) formed to cover a surface of said conductive polycrystal member (144; 160; 178); and

14

a second conductive polycrystal member (148; 164; 182) deposited to cover said second insulating film (146; 162; 180).

13. The memory device according to claim 12, characterized in that said first conductive polycrystal member (144) has a T-shaped section.

14. The memory device according to claim 12, characterized in that said first conductive polycrystal member (160) has an H-shaped section.

15. The memory device according to claim 12, characterized in that said first conductive polycrystal member (178) has a sectional shape obtained by stacking two T-shaped layers.

16. The memory device according to claim 7 or 8, characterized in that said charge holding element (Ca) includes:

an insulating film (200) essentially consisting of $Ta_2O_5$; and

conductive layers (202, 204) opposite to each other to sandwich said insulating film (200).

F I G. 1

F I G. 2

F I G.    3

F I G.    4

f = 1HZ
c = 470 nF

F I G. 5A

f = 10HZ
c = 68nF

F I G. 5B

f = 100HZ
c = 68nF

F I G. 5C

f = 1kHz
c = 68nF

F I G. 5D

F I G. 6

F I G. 9

F I G. 7

F I G. 8

F I G. 10

F I G. 11

F I G. 12

F I G. 13

F I G. 14

F I G. 15

F I G. 16

FIG. 17

EP 0 395 886 A2

106　108

104

14

F I G.　18A

110
108

14

F I G.　18B

As⁺

104a
112
114

14

F I G.　18C

F I G. 18D

F I G. 18E

F I G. 18F

128   126

124

108

n+

116

114

14

F I G.   19

124

108

116

114

14

F I G.   20A

14

F I G.   20B

F I G. 21

F I G. 22A

F I G. 22B

F I G. 22C

F I G. 22D

156

144

152

150

14

154

F I G. 24A

156

152

144

F I G. 24B

146

144

148 144 146

14

F I G. 24C

148

F I G. 23

F I G. 24D

158

148

F I G. 24E

F I G.    26A

F I G.    26B

F I G.    26C

F I G.    25

F I G.    26D

F I G. 27

F I G. 28A

F I G. 28B

F I G. 28C

F I G. 28D

F I G. 28E

F I G. 29

F I G. 30A

F I G. 30B

F I G. 30C

F I G. 31

F I G. 32A

F I G. 32B

F I G. 32C

F I G. 33

EP 0 395 886 A2

EP 0 395 886 A2

F I G. 34

F I G. 35